# EUROPEAN PATENT SPECIFICATION

(11) **EP 2 265 742 B1**
(45) Date of publication and mention of the grant of the patent: **14.01.2015**
(21) Application number: 09714034.7
(22) Date of filing: 26.02.2009
(51) Int. Cl.: C23C 10/08, C23C 30/00, C23C 14/02, C23C 16/02

(54) **CORROSION RESISTANT OBJECT WITH ALLOYING ZONE**
KORROSIONFESTIGES OBJEKT MIT LEGIERTEM BEREICH
OBJET RÉSISTANT À LA CORROSION COMPORTANT UNE ZONE EN ALLIAGE

(30) Priority: 28.02.2008 DK 200800291
(43) Date of publication of application: 29.12.2010
(73) Proprietor: Danfoss A/S, 6430 Nordborg (DK)
(72) Inventor: GILLESBERG, Bo, DK-6440 Augustenborg (DK); ERIKSEN, Søren, DK-4000 Roskilde (DK)
(74) Representative: Jennings, Nigel Robin
(86) International application number: PCT/DK2009/000052
(87) International publication number: WO 2009/106079

(56) References cited:
- EP-A1- 1 995 344
- WO-A-2006/133710
- WO-A-2008/006379

## Description

This invention relates to objects having a corrosion resistant surface improving the overall corrosion resistance of the object relative to the core material, preferably being titanium or titanium based. The surface layer preferably contains at least 80% of a refractory metal such as tantalum, or an alloy based on one or more refractory metals, To ensure a good adhering of the surface to the base material an alloy layer is created between a core element and the surface layer having a thickness at least twice that of the surface layer, where the alloy layer itself has corrosion resistant properties.

### BACKGROUND OF THE INVENTION

Objects which are meant to be positioned in highly corrosive environments must have an outer surface which is corrosion resistant in order to protect the object. Such a corrosion resistant outer surface may be provided by manufacturing the entire object from a corrosion resistant material. This may, however, be undesirable, e.g. due to the costs involved in manufacturing such an object, or because the corrosion resistant material may fail to meet other requirements or properties which the object has to fulfil or have, e.g. in terms of strength, magnetic properties, flexibility, durability, density, weight, thermal or electrical conductivity, workability (e.g. with respect to pressing, stamping, welding, forging, screwing, soldering or gluing), elasticity, fatigue properties, lubrication related properties, hardness, roughness, etc. Accordingly, a corrosion resistant outer surface is often provided by coating the object with a layer of corrosion resistant material, such as tantalum (Ta), Niobium (Nb), zirconium (Zr), Tungsten (W), Titanium (Ti) or alloys, that includes one or more of these materials in a concentration of at least 10%

It is vital that such a surface layer is tight without pinholes creating exposed spots of the object under the coating to the highly corrosive environments, and a number of documents describes methods to apply such a pinhole free layer, such as EP0578605B1 describing a molten bath for plating with high-melting metals, in particular niobium and tantalum. The bath consists of an alkali metal fluoride melt, which contains oxide ions and ions of the metal to be precipitated. The molar ratio between the metal to be precipitated and the oxide ions, or the other cat ions in the melt, must be held within given ratios. The redox level must be held at a value which corresponds to that which is reached when the molten bath is in contact with the particular high-melting metal in the metallic form.

WO2008/006379 teaches a method for treating titanium based objects with a surface layer of mixed tantalum and titanium oxides. Following diffusion a tantalum-titanium alloy is formed and the tantalum concentration decreases towards the inner part of the object. EP 1995344 teaches also the formation of a Ti-Ta alloy formed by diffusion on a titanium based object.

### SUMMERY OF THE INVENTION

The object of the invention is achieved as set forth in claim 1.

A first aspect of the invention is to ensure good attachment to a base material and mechanical performances of the surface layer. This is ensured by the formation of a diffusion zone, or alloying zone. This alloying zone ensures that the resistant surface is sufficiently ductile to let the surface, or the whole object, being mechanically modified without creating cracks or other weaknesses undermining or damaging the corrosion resistance. The base material is titanium based.

A further aspect of the invention is to ensure that the alloying zone itself has corrosion resistant properties, and, should the surface layer fail due to damage, wear, slow corrosion, then to give means for estimating the corrosion speed, a thereby the remaining life time of the object, given the corrosion environment. This is ensured by the alloying zone being deep in relation to the thickness coating, and where the content of the main substance, or the corrosion resistant material, of the surface layer (like Ta) decreases into the alloying zone, so that the corrosion resistance decreases into the alloying zone.

Defining the thickness of the surface layer as the thickness from the surface to where the concentration of the corrosion resistant material is reduced to 90% of the concentration of the surface layer, or if the surface layer is an alloy then where the concentration of one of the corrosion resistant materials is reduced to 90% of the concentration of the surface layer. At this 90% limit the alloying zone is defined to begin. The thickness of the alloying zone is defined as the thickness from the beginning of the alloying zone, to the depth where the concentration of the corrosion resistant material, or if the surface is an alloy then the concentration of one of the corrosion resistant materials are reduced to10% of the concentration at the 90% limit, the beginning of the alloying layer.An alternative definition of the allying zone is that the depth is defined as the depth from the beginning of the alloying zone, where the total concentration of the corrosion resistant material is down to 20%, averaged over the depth.

Typically half of the deposited tantalum is alloyed into the material giving an alloying zone 2-3 times the thickness of the surface layer. For example having a 10 micrometers surface layer and a 25 micrometers alloying zone.

If the surface layer has been damaged or even removed by wear or slowly corrosion, the alloying zone having better corrosion resistance than the base material still offers some protection giving rise to a slow corrosion attack, only., From a measurement of the content of the corrosion resistant material in the actual surface, the corrosion speed and hence the remaining service life, may be predicted (given a known corrosion environment).

The alloying zone and the surface layer is preferably formed by a CVD process.

### FIGURES.

- Fig. 1: The object of the invention showing a base material with a surface layer and an alloying zone there between.
- Fig. 2: The object of the invention where the surface layer and part of the alloying zone has been removed.

### DETAILED DESCRIPTION

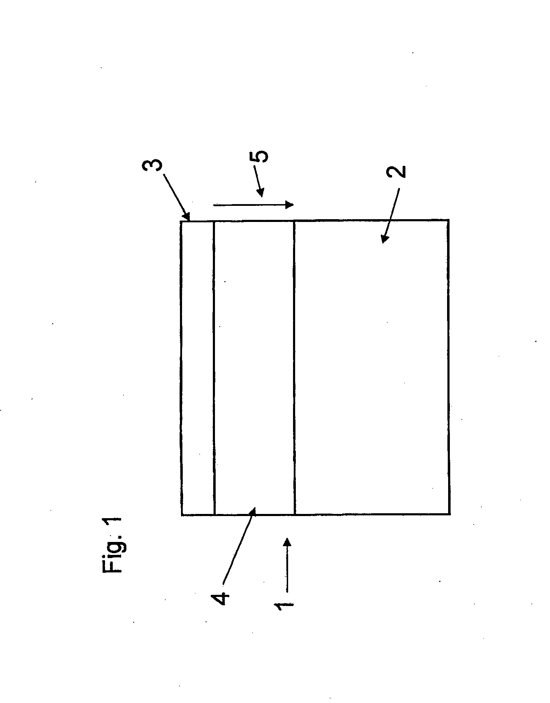

Fig. 1 illustrates the object (1) of the invention having a base element (2) not limiting being of a titanium based material. The object has a corrosion firm surface layer (3) comprising a concentration of at least 80% of a corrosion resistant material like Ta, Nb, W, Ti, or other refractory metals. The thickness of the surface layer is defined as the thickness from the surface to where the concentration of the corrosion resistant material (like Ta or Ti) is 90% of the total concentration of the surface layer, where the alloying zone is defined to begin.

An alloying zone (4) is formed between the base element (2) and the surface layer (3) with a decreasing concentration of the corrosion resistant material into the object, being illustrated by the direction of arrow (5). The thickness of the alloying zone is defined as the thickness from the beginning of the alloying zone, to the depth where the concentration has fallen to 10% of the concentration at the beginning of the zone.

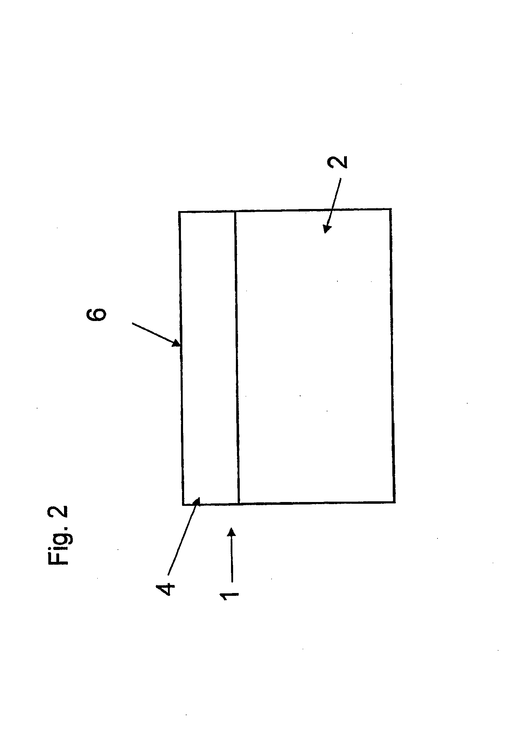

Fig. 2 illustrates the system after a graduated decrease of the corrosion firmness into the deposit, meaning that the coating (3), or surface layer, has been damaged, removed by wear or slowly corrosion, giving a slow corrosion attack, that also has removed part of the alloying zone (4).

These lowered corrosion abilities reflect the composition of the actual surface (6) of the object (1), being gradually changed into the alloying zone having a decreasing concentration of the corrosion resistant material. From a measurement of the content of the corrosion resistant material in the actual surface (6), then the corrosion speed, or the remaining service life, may be predicted (given a known corrosion environment).

## Claims

1. An object (1) having a base element (2) of a titanium based material, a corrosion resistant surface layer (3) comprising a corrosion resistant material and having a first thickness defined as the thickness of the surface layer from the surface to where the concentration of the corrosion resistant material is reduced to 90%, and where an alloying zone (4) is formed between the base element (2) and the surface layer (3) with a decreasing concentration of said corrosion resistant material into the object, where the alloying zone (4) has a second thickness defined as the thickness from where the concentration of the corrosion resistant material is reduced to 90% to the depth where the concentration of the corrosion resistant material is reduced to10% of the concentration at the 90% limit, **characterized in that** the second thickness is at least two times that of the first thickness and the alloying zone (4) itself has corrosion resistant properties with a decreasing corrosion resistance into the alloying zone (4)

2. Object as in claim 1, wherein surface layer (3) has a concentration of at least 80% of corrosion resistant material being tantalum, niobium or tungsten.

3. Method to estimate the remaining service life span of the object in claim 2, the method based on the measurement of the concentration of the corrosion resistant material at the actual surface (6).

## Patentansprüche

1. Objekt (1) mit einem Basiselement (2) aus einem titanbasierten Material, einer korrosionsfesten Oberflächenschicht (3), die ein korrosionsfestes Material aufweist und eine erste Stärke aufweist, die als die Stärke der Oberflächenschicht von der Oberfläche bis dahin, wo die Konzentration des korrosionsfesten Materials auf 90% verringert ist, definiert ist, und wobei ein legierter Bereich (4) zwischen dem Basiselement (2) und der Oberflächenschicht (3) mit einer abnehmenden Konzentration des korrosionsfesten Materials in das Objekt hinein ausgebildet ist, wobei der legierte Bereich (4) eine zweite Stärke aufweist, die als die Stärke von dort, wo die Konzentration des korrosionsfesten Materials auf 90% verringert ist, bis zu der Tiefe, in der die Konzentration des korrosionsfesten Materials auf 10% der Konzentration an der 90%-Grenze verringert ist, definiert ist, **dadurch gekennzeichnet, dass** die zweite Stärke mindestens das Zweifache der ersten Stärke beträgt und der legierte Bereich (4) selbst korrosionsfeste Eigenschaften mit einer abnehmenden Korrosionsfestigkeit in den legierten Bereich (4) hinein aufweist.

2. Objekt nach Anspruch 1, wobei die Oberflächenschicht (3) eine Konzentration von mindestens 80% von korrosionsfestem Material aufweist, das Tantal, Niobium oder Wolfram ist.

3. Verfahren zum Schätzen der verbleibenden Nutzlebenszeit des Objekts gemäß Anspruch 2, wobei das Verfahren auf der Messung der Konzentration des korrosionsfesten Materials auf der tatsächlichen Oberfläche (6) basiert.

## Revendications

1. Objet (1) comprenant un élément de base (2) constitué d'un matériau à base de titane, une couche de surface résistant à la corrosion (3) comprenant un matériau résistant à la corrosion et présentant une première épaisseur définie comme étant l'épaisseur de la couche de surface à partir de la surface à laquelle la concentration du matériau résistant à la corrosion est réduite à 90 %, et dans lequel une zone en alliage (4) est formée entre l'élément de base (2) et la couche de surface (3) avec une concentration décroissante dudit matériau résistant à la corrosion dans l'objet, dans lequel la zone en alliage (4) présente une deuxième épaisseur qui est définie comme étant l'épaisseur à partir de l'endroit où la concentration du matériau résistant à la corrosion est réduite à 90 % jusqu'à la profondeur où la concentration du matériau résistant à la corrosion est réduite à 10 % de la concentration à la limite de 90 %, **caractérisé en ce que** la deuxième épaisseur est égale à au moins deux fois la première épaisseur, et la zone en alliage (4) elle-même présente des propriétés de résistance à la corrosion qui affichent une résistance à la corrosion décroissante dans la zone en alliage (4).

2. Objet selon la revendication 1, dans lequel la couche de surface (3) présente une concentration d'au moins 80 % de matériau résistant à la corrosion qui est le tantale, le niobium ou le tungstène.

3. Procédé d'estimation de la durée de service restante de l'objet selon la revendication 2, le procédé étant basé sur la mesure de la concentration du matériau résistant à la corrosion à la surface réelle (6).
